# EUROPEAN PATENT APPLICATION

(11) **EP 3 038 163 A1**
(43) Date of publication of application: **29.06.2016**
(21) Application number: 15197325.2
(22) Date of filing: 01.12.2015
(51) Int. Cl.: H01L 29/872, H01L 29/205, H01L 29/417, H01L 21/329

(54) **A GROUP III-N LATERAL SCHOTTKY BARRIER DIODE AND A METHOD FOR MANUFACTURING THEREOF**

(30) Priority: 23.12.2014 EP 14200017
(71) Applicant: IMEC VZW, 3001 Leuven (BE); Katholieke Universiteit Leuven, 3000 Leuven (BE)
(72) Inventor: Hu, Jie, 3001 Leuven (BE)
(74) Representative: Patent Department IMEC

(57) **Abstract**

A group III-N lateral Schottky diode is disclosed comprising a substrate (2), a nucleation layer (3) formed on the substrate (2), a buffer layer (4) formed on the nucleation layer (3), a group III-N channel stack (5) formed on the buffer layer (4), formed on the channel stack (5) a group III-N barrier (6) containing Aluminium whereby the Aluminium content of the barrier (6) decreases towards the channel stack (5), a passivation layer (8) formed on the group III-N barrier (6), a cathode (11) formed in an opening (9) through the passivation layer (8) whereby the opening (9) at least extends to the barrier (6), and; an anode (13) formed in another opening (10) through the passivation layer (8) thereby partially extending into the barrier (6), the anode forming a Schottky contact with the barrier (6).

## Description

### Field

The present disclosure relates to group III-N lateral Schottky barrier diodes. In particular, the disclosure relates to AlGaN/GaN lateral Schottky diodes.

### State of the art

Group III-N lateral Schottky barrier diodes, such as AlGaN/GaN Schottky Barrier Diodes (SBD's), are attractive for high-power switching applications. They offer appealing properties such as fast switching speed, low on-state resistance as well as a large breakdown voltage.

In order to obtain a low static power loss of such a Schottky diode in a switching circuit, the reverse diode leakage current and the forward diode voltage drop should be minimal.

N. Ikeda et al. discloses in 'A Novel GaN Device with Thin AlGaN/GaN Heterostructure for High-power Applications', Furukawa Review, No. 29 (2006), a dual Schottky metal barrier approach to reduce the static power loss. The anode contains two Schottky barrier metals. A low Schottky barrier metal is used to provide Ohmic-like behaviour in the on-state, while a high Schottky barrier metal is used to pinch-off the channel in the off-state. This approach requires two Schottky metals having different workfunctions which is typically not compatible with state-of-the-art CMOS processing.

Another approach is disclosed by W. Chen et al. in 'High-performance AlGaN/GaN lateral field-effect rectifiers compatible with high electron mobility transistors', Applied Physics Letters, 92, 253501 (2008). Here an enhancement-mode AlGaN/GaN High Electron Mobility Transistor (HEMT) is given a diode-like voltage-current behavior by electrically shortening the gate electrode and the source thereby reducing the turn-on voltage of the transistor.

Hence, there is a need for an group III-N lateral Schottky diode offering a reduced static power loss, while maintaining a high switching speed and a low reverse leakage current.

Such a lateral Schottky diode should be manufacturable using state-of-the-art CMOS manufacturing processes, whereby preferably Au is not needed as contact metal for the anode and/or cathode contact.

Such a Schottky diode could have a conventional diode architecture. In particular, such a Schottky diode could allow the monolithic integration of such group III-N lateral lateral Schottky diode with a group III-N High Electron Mobility Transistor (HEMT).

### Summary

A group III-N lateral Schottky diode is disclosed, the diode comprising: a substrate, a nucleation layer formed on the substrate, a buffer stack formed on the nucleation layer, a group III-N channel layer formed on the buffer stack, on the channel layer a group III-N barrier containing Aluminium whereby the Aluminium content of the barrier decreases towards the channel layer, a passivation layer formed on the group III-N barrier, a cathode formed in an opening through the passivation layer whereby the opening extends at least to the barrier, and an anode formed in another opening through the passivation layer thereby partially extending into the barrier, the anode forming a Schottky contact with the barrier.

In a preferred embodiment, the group III-N barrier comprises a first barrier layer formed on the channel layer and, a second barrier layer formed on the first barrier layer, whereby the Aluminium content of the first barrier layer is less than the Aluminium content of the second barrier layer. The first barrier layer can have an Aluminium content in the range of 1 at.% to 50 at.%. The first barrier layer and the second barrier layer can a layer thickness in the range of 1nm to 50nm.

The channel layer can be a Gallium Nitride channel layer in physical contact with an Aluminium Gallium Nitride barrier.

The cathode opening extends at least through the passivation layer, thereby forming an Ohmic contact with the two-dimensional electron gas present at the interface between the channel layer and the barrier. In the preferred embodiment, the anode opening extends into the first barrier layer.

The diode can further comprise an edge termination dielectric layer isolating the anode from the passivation layer and from the upper surface of the second barrier layer exposed in the anode opening. Optionally this edge termination dielectric layer may further isolate the anode from any surface of the second barrier layer exposed in the anode opening and from part of the surface of the first barrier layer exposed in the extended anode opening.

A method for manufacturing a group III-N lateral Schottky diode according to any of the foregoing paragraphs is disclosed, the method comprises providing a substrate, forming a nucleation layer on the substrate, forming a buffer stack on the nucleation layer forming a group III-N channel layer on the buffer stack, forming on the channel layer a group III-N barrier containing Aluminium whereby the Aluminium content of the barrier decreases towards the channel stack, forming a passivation layer on the group III-N barrier, forming an anode in an opening in the passivation layer which opening extends into the barrier whereby the anode is isolated at least from the passivation layer by an edge termination dielectric layer, the anode forming a Schottky contact with the barrier, and forming a cathode in an opening through the passivation layer which opening at least extends to the barrier whereby the cathode forms an Ohmic contact to a two-dimensional electron gas present at the interface between the channel layer and the barrier.

The group III-N barrier can be formed by forming a first barrier layer on the channel stack and, forming a second barrier layer on the first barrier layer, whereby the Aluminium content of the first barrier layer is less than the Aluminium content of the second barrier layer.

The anode can be formed by forming the opening through the passivation layer, forming the dielectric layer on the sidewalls and on the bottom of the opening, extending part of the opening through the dielectric layer into the barrier, and forming an anode in the opening to create a Schottky contact with the barrier.

Alternatively, the anode can be formed by forming the opening through the passivation layer, extending the opening into the barrier, forming the dielectric layer on the sidewalls and on the outer part of the bottom of the opening, and forming an anode in the opening to create a Schottky contact with the barrier.

### Brief description of the figures

For the purpose of teaching, drawings are added. These drawings illustrate some aspects and embodiments of the disclosure. They are only schematic and non-limiting. The size of some of the elements may be exaggerated and not drawn on scale for illustrative purposes. The dimensions and the relative dimensions do not correspond to actual reductions to practice of the disclosure. Like features are given the same reference number.
FIG 1 shows a typical diode characteristic of a group III-N Schottky barrier diode.
FIG 2 illustrates a schematic cross section of a Schottky barrier diode according to this disclosure.
FIG 3 shows a TCAD simulation of the potential energy band diagram of a Schottky barrier diode with double AlGaN barriers according to this disclosure, in the region between the anode and the cathode.
FIG 4 shows a TCAD simulation illustrating the shift in Schottky barrier height of a Schottky barrier diode according to this disclosure.
FIG 5 illustrates another schematic cross section of a Schottky barrier diode according to this disclosure.
FIG 6 illustrates another schematic cross section of a Schottky barrier diode according to this disclosure.

### Detailed description

The present disclosure will be described with respect to particular embodiments and with reference to certain drawings but the disclosure is not limited thereto. Furthermore, the terms first, second and the like in the description, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein. Moreover, the terms top, under and the like in the description are used for descriptive purposes and not necessarily for describing relative positions. It is to be understood that the terms so used are interchangeable under appropriate circumstances and that the embodiments of the disclosure described herein are capable of operation in other orientations than described or illustrated herein.

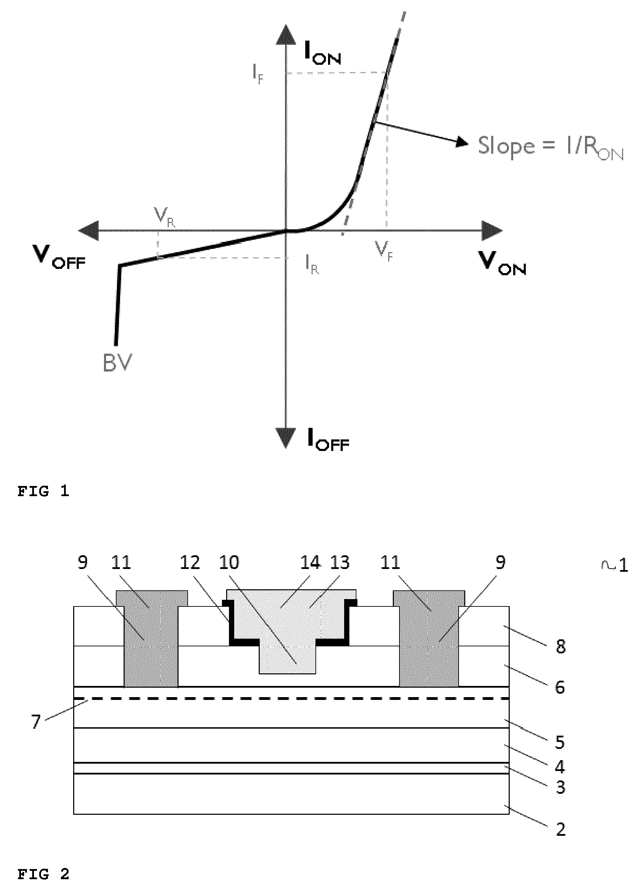

FIG 1 shows a typical diode characteristic of a group III-N Schottky diode, such as a AlGaN/GaN Schottky diode. The forward voltage (V_{F}) of such a Schottky diode depends on the turn-on voltage (V_{T}), the on-state resistance (R_{ON}), and the forward current (I_{F}) of the diode. According to this disclosure, both the turn-on voltage and the on-state resistance will be reduced thereby lowering the forward voltage and hence the static power loss, while maintaining other properties of the diode such as its fast switching speed and its large breakdown voltage (BV).

This turn-on voltage mainly depends on the barrier height of the Schottky barrier. The on-state resistance of the Schottky diode depends on the density and mobility of two-dimensional electron gas (2DEG) (7) formed at the interface between the group III-N channel stack (5) and group III-N barrier (6). According to this disclosure this reduction in turn-on voltage and the on-state resistance is achieved by engineering the group III-N barrier (6).

FIG 2 shows a schematic cross-section of a Schottky barrier diode according to this disclosure. The group III-N lateral Schottky diode (1) comprises a substrate (2), a nucleation layer (3) formed on the substrate (2), a buffer stack (4) formed on the nucleation layer (3), a group III-N channel (5) formed on the buffer stack (4), on the channel layer (5) a group III-N barrier (6) containing Aluminum, whereby the Aluminum content of the barrier (6) decreases towards the channel layer (5), a passivation layer (8) formed on the group III-N barrier (6), a cathode (11) formed in an opening (9) through the passivation layer (8), the opening (9) at least extending through the barrier (6), and an anode (13) formed in another opening (14) through the passivation layer (8) thereby partially extending (10) into the barrier (6), the anode forming a Schottky contact with the barrier (6). The opening (9) can extend till the barrier (6). Optionally the opening (9) can further extend into the barrier (6).

As known in the art, the substrate (2) can be any substrate used in the manufacturing of group III-N devices, e.g. silicon, silicon-carbide or sapphire. On top of this substrate the semiconducting layers of the Schottky barrier diode (1) are epitaxial grown whereby the nucleation layer (3) is configured to reduce the mismatch between the substrate (2) and the buffer stack (4). An advantage of the disclosed diode is that this epitaxial grown stack is compatible with the manufacturing of the group III-N High Electron Mobility Transistors (HEMT), thereby allowing monolithically integration of the disclosed diode with HEMT on a single substrate.

On the nucleation layer (3), a buffer stack (4) is present. In case of a Gallium Nitride Schottky diode (1), the buffer stack (4) typically contains several Aluminum Gallium Nitride layers having different Aluminum content and different layer thickness. The number, the Aluminum content and the layer thickness are selected to improve the buffer breakdown voltage and/or wafer bow, thereby allowing a high quality Gallium Nitride channel stack (5) to be grown on top.

On the buffer stack (4) a group III-N channel layer (5) is present.

A group III-N barrier (6) containing Aluminum is present on the channel layer (5). The Aluminum content of the barrier (6) decreases towards the channel layer (5).

Due to the polarization effect and the potential energy band offset between the channel layer (5) and the barrier (6), a two-dimensional electron gas (2DEG) (7) is formed in the channel layer (5) near the interface with the barrier (6). In the on-state, an electrical current will flow from the anode to the cathode through this 2DEG layer (7) having a high electron density and high electron mobility.

On top of the barrier (6) a passivation layer (8) is present. This layer (8) passivates dangling bonds at the surface of the barrier (6) and shields the epitaxial stack from external contamination.

In this passivation layer (8) two openings (9, 14/10) are created to respectively form the Ohmic cathode (11) and the Schottky barrier anode (13). The cathode opening (9) extends at least through the barrier (6), i.e. till or into the barrier (6). The metal or metals of the cathode then forms a low Ohmic contact to the 2DEG (7). A dielectric layer (12) is deposited in the opening (14/10) covering the exposed surface of the barrier (6) and the sidewalls of the passivation layer (8). The anode opening (14) extends through the passivation layer (8) and through this dielectric layer (12) partially (10) into the barrier (6). The metal or metals of the anode then forms a Schottky contact with the lower part of the barrier (6)) having a lower Aluminum content. By determining the depth of both openings (9,10), the cathode (11) and the anode (13) can contact parts of the barrier layer having a different Aluminum content.

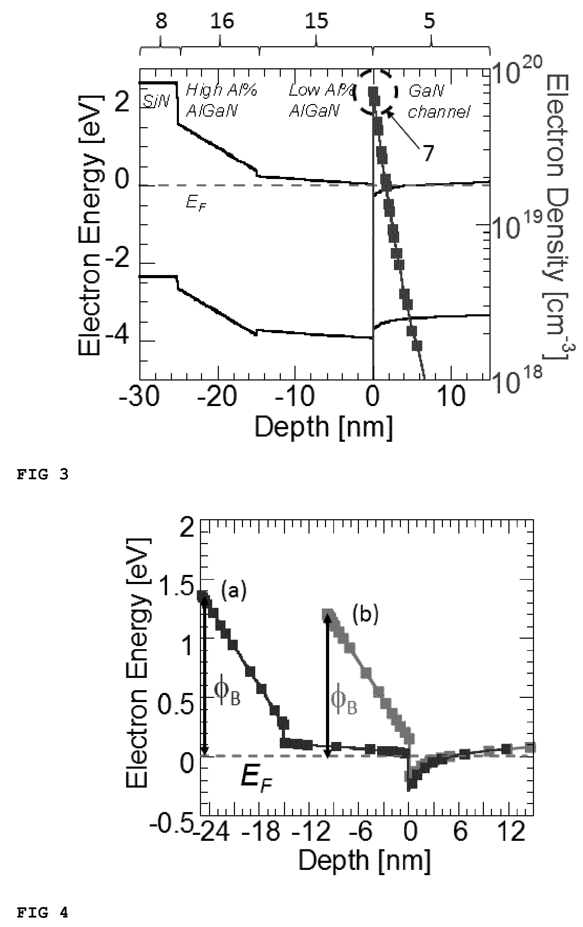

FIG 3 shows a simulated potential energy band diagram (solid line) and the 2DEG density (filled squares) illustrating the effect of having a group III-N barrier (6) with decreasing Aluminum content towards the channel layer (5) for Gallium Nitride Schottky diode. Here the barrier (6) contains two or more AlGaN layers. This stack of AlGaN layers allows a high electron density of the 2DEG (7) formed in the AlGaN (6)/GaN (5) quantum well resulting in the desired low on-state resistance during on-state operation. Here a SiN layer is used as passivation layer (8), but other dielectric layers can be used as well.

The Schottky metal of the anode (13) is in contact with the AlGaN barrier (6) having the lower Aluminum content, i.e. nearer to the channel layer (6). Hence the Schottky barrier height φ_{B} will be low. In the access region between the anode and cathode, the barrier layer is not recessed resulting in a low R_{ON}.

FIG 4 illustrates the reduction of the Schottky barrier height φ_{B} by the recessing (10), at the location of the anode (13), the portion (16) of AlGaN barrier (6) having the higher Aluminum content. This reduced Schottky barrier height φ_{B} allows the diode (1) to turn-on earlier as it has a lower turn-on voltage. In the region between the anode (13) and the cathode (11), the full AlGaN barrier (6) remains, resulting in a low R_{ON}. Hence a low forward voltage of the diode (1) during on-state operation is obtained.

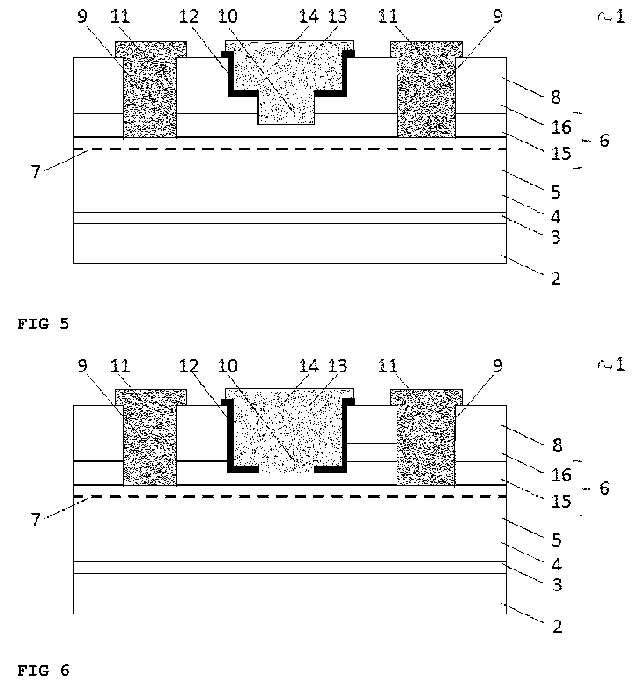

FIG 5 shows a schematic cross section of Schottky barrier diode (1) having characteristics as illustrated by FIG 3 and FIG 4. This embodiment differs from the embodiment illustrated by FIG 2 in that the group III-N barrier (6) now comprises a first barrier layer (15) formed on the channel layer (5) and a second barrier layer (16) formed on the first barrier layer (15). The Aluminum content of the first barrier layer (15) is less than the Aluminum content of the second barrier layer (16). Here the cathode opening (9) is etched through the passivation layer (8) till or into barrier layer (6) or even into channel layer (5) to electrically contact the 2DEG (7).

FIG 6 shows an alternative embodiment. This embodiment differs from the embodiment illustrated by FIG 5 in the shape of the anode opening (10/14). In this embodiment, the opening (14) in the passivation layer (8) has the same dimension as the opening (10) in the barrier layer (6). The channel layer (5) can be a Gallium Nitride channel layer, while the group III-N barrier (6) can be an Aluminum Gallium Nitride barrier. In such configuration, the first barrier layer (15) typically has an Aluminum content in the range of 1 at.% to 50 at.% (atomic percentage). The Aluminum content of the second barrier layer (16) then varies between the effective aluminum content of the first barrier layer (15) and 100 at. %. The layer thickness of the first barrier layer (15) and of the second barrier layer (16) is preferably in the range of 1nm to 50nm (nanometer).

To further reduce the static power loss, the leakage current can be reduced using Edge Termination (12). This layer (12) suppresses the high electric field at the corners of Schottky contact (13) in the off-state. This edge termination is typically formed by depositing a dielectric layer such as silicon nitride, silicon oxide or alumina oxide at least in the corners of the Schottky barrier anode (13).

FIG 5 illustrates a first implementation of the edge termination. The anode opening (10) is stepwise having a larger dimension in the passivation layer (8) then in the barrier (6) such that, within the anode opening (10) part of the upper surface of the second barrier layer (16) is exposed. The dielectric layer (12) covers the passivation layer (8) isolating the anode (13) therefrom and covers this exposed upper surface of the second barrier layer (16). In the smaller sized part of the anode opening (10), the anode (13) contacts the exposed sidewalls of the second (16) and first (15) barrier layer and at the bottom the first barrier layer (15).

FIG 6 illustrates an alternative implementation of this edge termination. Here the anode opening (10) has a constant dimension when extending into the diode (1). The dielectric layer (12) covers the passivation layer (8) and the exposed sidewalls of the second (16) and first (15) barrier layer. This isolates the anode (13) from the passivation layer (8) and the second barrier layer (16). At the bottom of the anode opening (10), an opening in the edge termination dielectric layer (12) is present to allow direct contact between the anode (13) and the first barrier layer (15).

A method for manufacturing a group III-N lateral Schottky diode (1) according to any of the foregoing paragraphs is disclosed, the method comprises: providing a substrate (2), forming a nucleation layer (3) on the substrate (2), forming a buffer stack (4) on the nucleation layer (3), forming a group III-N channel layer (5) on the buffer stack (4), forming on the channel layer (5) a group III-N barrier (6) containing Aluminium, whereby the Aluminium content of the barrier (6) decreases towards the channel stack (5), forming a passivation layer (8) on the group III-N barrier (6), forming an anode (13) in an opening (10,14) in the passivation layer (8) extending into the barrier (6) whereby the anode (6) is isolated at least from the passivation layer (8) by an edge termination dielectric layer (12), the anode forming a Schottky contact with the barrier (6), and; forming a cathode (11) in an opening (9) through the passivation layer (8), at least extending to the barrier (6), the cathode (11) forming an Ohmic contact to a two-dimensional electron gas (7) present at the interface between the channel layer (5) and the barrier (6).

The group III-N barrier (6) can be formed by forming a first barrier layer (15) on the channel stack (5), and, forming a second barrier layer (16) on the first barrier layer (15), whereby the Aluminium content of the first barrier layer (15) is less than the Aluminium content of the second barrier layer (16). Preferably the channel layer (5) is a Gallium Nitride channel layer, and the barrier (6) is an Aluminium Gallium Nitride barrier. Preferably the first barrier layer (15) has an Aluminium content in the range of 1 at.% to 50 at.%, and the second barrier layer (16) has an Aluminium content between the Aluminium content of the first barrier layer (15) and 100 at.%. Preferably the first barrier layer (15) and the second barrier layer (16) have a layer thickness in the range of 1 nm to 50 nm.

The anode (13) can be formed by forming the opening (14) through the passivation layer (8), forming the dielectric layer (12) on the sidewalls and on the bottom of the opening (14), extending (10) part of the opening (14) through the dielectric layer (12) into the barrier (6), and then forming the anode (13) in the opening (10,14) to create a Schottky contact with the barrier (6). The resulting device is illustrated by FIG 5.

Alternatively, the anode (13) can be formed by forming the opening (14) through the passivation layer (8), extending (10) the opening (14) into the barrier (6), forming the dielectric layer (12) on the sidewalls and on the outer part of the bottom of the opening (10,14), and then forming the anode (13) in the opening (10,14) to create a Schottky contact with the barrier (6). This resulting device is illustrated by FIG 6.

In the foregoing method for manufacturing a group III-N Schottky diode (1) the anode (13) is formed prior to the cathode (11). In an alternative method the cathode (11) is formed prior to the anode (13). This alternative method differs from the foregoing method in that after forming the passivation layer (8) on the group III-N barrier (6), an opening (9) is formed through the passivation layer (8) which opening (9) at least extends to the barrier (6). In this opening (9) the cathode (11) is formed. Thereafter another opening (14) is formed through the passivation layer (8) which another opening (14) partially extends (10) into the barrier (6). In this extended opening (10,14) the anode (13) is formed thereby creating a Schottky contact with the barrier (6).

The disclosed architecture of a group III-N Schottky barrier diode, in particular of a lateral AlGaN/GaN Schottky diode, allows the reduction of static power loss during both the on-state and the off-state.

## Claims

1. A group III-N lateral Schottky diode (1) comprising:
- a substrate (2),
- a nucleation layer (3) formed on the substrate (2),
- a buffer stack (4) formed on the nucleation layer (3),
- a group III-N channel layer (5) formed on the buffer stack (4),
- on the channel layer (5) a group III-N barrier (6) containing Aluminium whereby the Aluminium content of the barrier (6) decreases towards the channel layer (5),
- a passivation layer (8) formed on the group III-N barrier (6),
- a cathode (11) formed in an opening (9) through the passivation layer (8), the opening (9) at least extending to the barrier (6), and;
- an anode (13) formed in another opening (14) through the passivation layer (8) thereby partially extending (10) into the barrier (6), the anode forming a Schottky contact with the barrier (6).

2. The device of claim 1, where:
the group III-N barrier (6) comprises a first barrier layer (15) formed on the channel layer (5), and, a second barrier layer (16) formed on the first barrier layer (15), whereby the Aluminium content of the first barrier layer (15) is less than the Aluminium content of the second barrier layer (16).

3. The device of claim 2, wherein:
the channel layer (5) is a Gallium Nitride channel layer, and the barrier (6) is an Aluminium Gallium Nitride barrier.

4. The device of claim 3, wherein:
the first barrier layer (15) has an Aluminium content in the range of 1 at.% to 50 at.%.

5. The device of claim 4, wherein:
the first barrier layer (15) and the second barrier layer (16) have a layer thickness in the range of 1nm to 50nm.

6. The device of any of the claims 2 to 5, wherein:
a two-dimensional electron gas (7) is present at the interface between the channel layer (5) and the barrier (6),
and; the cathode opening (9) extends at least through the passivation layer (8) thereby forming an Ohmic contact with the two-dimensional electron gas (7).

7. The device of any of the claims 2 to 6, wherein the anode opening (14) extends (10) into the first barrier layer (15).

8. The device of claim 7, further comprising:
an edge termination dielectric layer (12) isolating the anode (13) from the passivation layer (8) and from the upper surface of the second barrier layer (16) exposed in the anode opening (14).

9. The device of claim 8, wherein:
the edge termination dielectric layer (12) further isolates the anode (13) from any surface of the second barrier layer (16) exposed in the anode opening (14) and from part of the surface of the first barrier layer (15) exposed in the extended anode opening (10).

10. A method for manufacturing a group III-N lateral Schottky diode (1) according to any of the foregoing claims, the method comprising:
- providing a substrate (2),
- forming a nucleation layer (3) on the substrate (2),
- forming a buffer stack (4) on the nucleation layer (3),
- forming a group III-N channel layer (5) on the buffer stack (4),
- forming on the channel layer (5) a group III-N barrier (6) containing Aluminium, whereby the Aluminium content of the barrier (6) decreases towards the channel stack (5),
- forming a passivation layer (8) on the group III-N barrier (6),
- forming an anode (13) in an opening (14) in the passivation layer (8) extending (10) into the barrier (6) whereby the anode (6) is isolated at least from the passivation layer (8) by an edge termination dielectric layer (12), the anode forming a Schottky contact with the barrier (6), and;
- forming a cathode (11) in an opening (9) through the passivation layer (8), at least extending to the barrier (6), the cathode (11) forming an Ohmic contact to a two-dimensional electron gas (7) present at the interface between the channel layer (5) and the barrier (6).

11. The method of claim 10, wherein forming a group III-N barrier (6) comprises:
forming a first barrier layer (15) on the channel stack (5), and, forming a second barrier layer (16) on the first barrier layer (15), whereby the Aluminium content of the first barrier layer (15) is less than the Aluminium content of the second barrier layer (16).

12. The method of claim 10 or 11, wherein forming an anode (13) comprises:
- forming the opening (14) through the passivation layer (8),
- forming the dielectric layer (12) on the sidewalls and on the bottom of the opening (14),
- extending (10) part of the opening (14) through the dielectric layer (12) into the barrier (6), and;
- forming an anode (13) in the opening (10,14), the anode forming a Schottky contact with the barrier (6).

13. The method of claim 10 or 11, wherein forming an anode (13) comprises:
- forming the opening (14) through the passivation layer (8),
- extending (10) the opening into the barrier (6),
- forming the dielectric layer (12) on the sidewalls and on the outer part of the bottom of the opening (10,14), and;
- forming an anode (13) in the opening (10,14), the anode forming a Schottky contact with the barrier (6).
